Europäisches Patentamt

European Patent Office

Office européen des brevets

(11) Publication number: **0 459 070 A1**

# EUROPEAN PATENT APPLICATION

(21) Application number: 90830247.4

(22) Date of filing: **31.05.90**

(51) Int. Cl.5: **H03F 1/02**, H03F 3/45, H03F 1/32

(43) Date of publication of application:
**04.12.91 Bulletin 91/49**

(84) Designated Contracting States:
**DE FR GB IT NL SE**

(71) Applicant: **SGS-THOMSON MICROELECTRONICS s.r.l.**
**Via C. Olivetti, 2**
**I-20041 Agrate Brianza Milano(IT)**

(72) Inventor: **Gola, Alberto**
**Via Eseguiti 22 bis**
**I-27043 Broni(IT)**
Inventor: **Salina, Alberto**
**Viale Piave 20**
**I-20051 Limbiate(IT)**

(74) Representative: **Pellegri, Alberto et al**
**c/o Società Italiana Brevetti S.p.A. Via Cavour, 9**
**I-21100 Varese(IT)**

(54) **High slew-rate operational amplifier with bias controlled by the input differential signal.**

(57) An operational amplifier employs split collector transistors ($Q_1$, $Q_2$) for the input differential pair. Through a fractional collector of the input transistors ($Q_1$, $Q_2$) a fraction of the currents (1/4) flowing through the two branches of the input differential stage is derived and by means of two complementary mirrors ($Q_9$ - $Q_{12}$) having a sufficiently high, combined mirror-ratio, this current, which is proportional to the amplitude of the signal present across the input terminals of the amplifier, is fed as a biasing current (I) to the input node of the output buffer stage ($Q_x$, $Q_y$) of the amplifier in order to enhance the slew-rate behaviour by ensuring a fast charging of the frequency compensation capacitance ($C_c$) during a transient condition while maintaining a low power dissipation under small signal steady state conditions.

FIG.5

*BACKGROUND OF THE INVENTION*

1. Field of the invention

The invention relates to an operational amplifier having a high slew-rate, achieved without increasing the offset and the current drawn under steady state conditions.

2. Description of the prior art

A problem encountered in designing an operational amplifier with a high slew-rate is the dependence of this parameter from the bias current of the differential input stage of the amplifier.

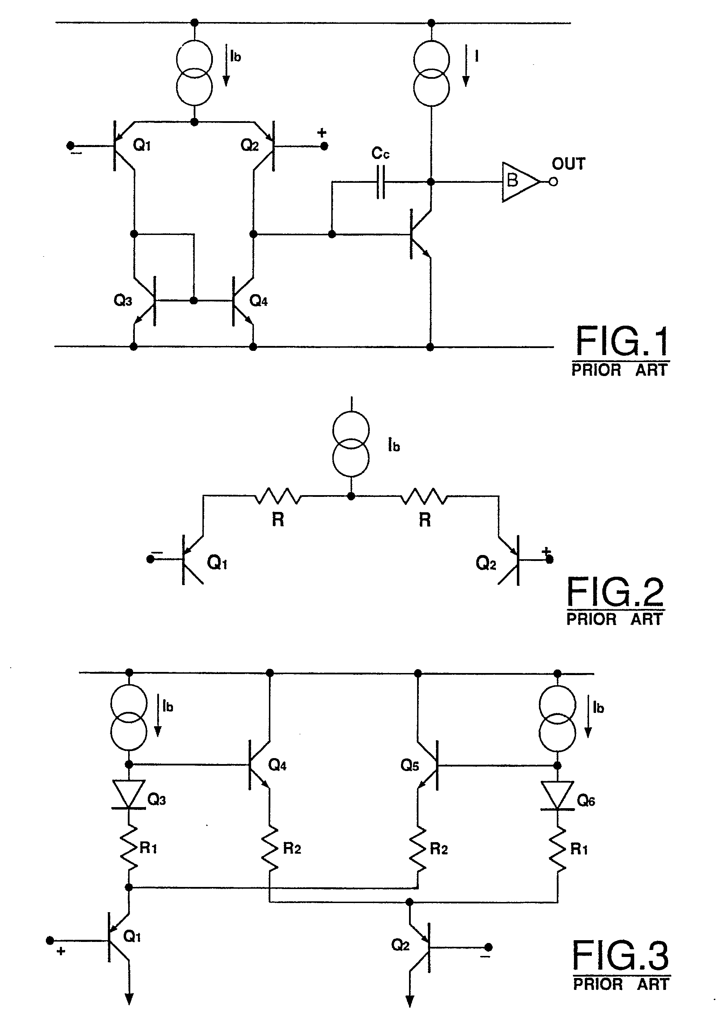

By considering the typical circuit diagram of a standard operational amplifier, depicted in Fig. 1, the slew-rate, defined as the maximum output voltage swing per unit time is given by $I_B/C_c$, where $I_B$ is the bias current of the differential input stage and $C_c$ is the compensation capacitance which determines the small signal frequency response of the amplifier. It is known from literature that the value of the compensation capacitance may not be decreased beyond a certain limit because this would lead to instability, while $I_B$ cannot be increased unlimitedly for two reasons:
- power dissipation considerations;
- the transconductance of the differential input stage (gm), from which the bandwidth depends, i.e. BW = $gm/2\pi C_c$, depends on the value of the bias current $I_B$ and consequently if $I_B$ is increased it is necessary to increase the compensation capacitance $C_c$ too in order to avoid instability, therefore increasing $I_B$ isn't really a solution.

A first known technique for increasing the slew-rate is that of untying the transconductance from the bias current level. Such a result is practically obtained by resistive emitter degeneration of the two transistors forming the input pair, by adding a resistance R in series with the emitters of the two transistors, as schematically depicted in Fig. 2.

This technique is discussed in the article "The Monolithic OP AMP: A Tutorial Study" by James E. Solomon, IEEE Journal of Solid-State Circuits, Vol. SC-9, Number 6, December 1974.

This technique has a drawback represented by an increased offset introduced by the addition of the resistances R and by the necessity of increasing the rest bias current $I_B$.

In a recently developed alternative technique, the bias current of the differential input stage is made to vary in function of the amplitude of the differential signal fed across the input terminals of the input stage. The relative circuit is depicted in Fig. 3. It may be shown that under a slew-rate condition, e.g. when a step potential equal to V is applied across the noninverting (+) and the inverting (-) input terminals of the amplifier, the currents through the input pair of transistors $Q_1$ and $Q_2$ are respectively given by the following expressions:

$$IQ_1 = Ib\ \frac{R_1}{R_2}\ -\ V/R_2 \qquad\qquad IQ_2 = Ib\ \frac{R_1}{R_2}\ +\ V/R_2$$

with a good degree of approximation. In other words the current of the differential input stage, when this is unbalanced, is directly proportional to the "unbalance" between the input terminals (amplitude of the differential input signal).

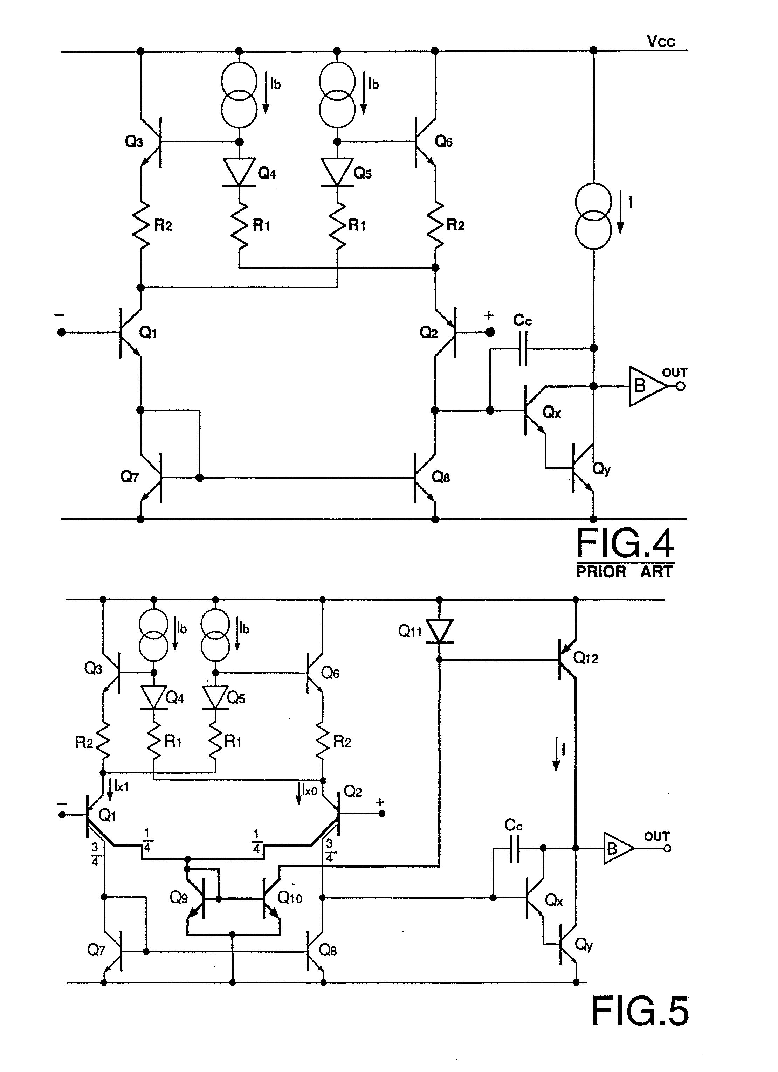

When employing this technique, the circuit diagram of the operational amplifier is as depicted in Fig. 4.

This second technique is only partly effective. The current delivered by the input stage varies in function of the amplitude of the differential input signal, however the current I, which is responsible for the charging of the frequency compensation capacitance $C_c$ during a transition toward a high level of the output voltage (noting that during a transition in an opposite direction, the Darlington pair $Q_x$ and $Q_y$ conducts and therefore there are no particular driving problems) must be at least equal to the maximum current delivered during a transient by the input differential stage. If, comprehensively, such a current I must necessarily be of several milliamperes (mA), this may represent a problem in terms of power dissipation, because the current I must be delivered also during steady state conditions.

There remains a need for an operational amplifier with a high slew-rate wherein the current drawn under

EP 0 459 070 A1

steady state conditions may notwithstandingly be maintained relatively low.

*SUMMARY OF THE INVENTION*

The operational amplifier of the invention provides a solution to the above mentioned problem.

Basically, in the operational amplifier object of the present invention, the output biasing current of the intermediate gain stage of the amplifier, which current is responsible for the charging of the frequency compensation capacitance, is made variable and proportional to the amplitude of the input differential signal. This is achieved by mirroring a fraction of the currents flowing through the input differential pair of transistors on the input node of the output buffer stage (i.e. on the output node of the intermediate gain state) with a sufficiently high mirroring ratio. The fraction of the currents flowing through the input differential pair of transistors is derived by forming a split collector in the structure of the latter transistors.

In this way the bias current on the input node of the output buffer stage of the amplifier is made capable of following the current variations imposed by the input differential stage without any appreciable lag time due to the charging of the frequency compensation capacitance. This makes the slew-rate effectively determined by the potential difference across the input terminals, and perfectly symmetric (i.e. the step variation of the output voltage toward a positive voltage level is identical to a variation toward a negative voltage of the same level).

This permits to the bias currents of the entire operational amplifier to be kept relatively low, in order to limit power dissipation, during steady state conditions.

*BRIEF DESCRIPTION OF THE DRAWINGS*

**Fig. 1** is the circuit diagram of a standard operational amplifier.

**Fig. 2** is a partial diagram showing a first known technique for improving the slew-rate.

**Fig. 3** is a partial diagram showing an alternative known technique for improving the slew-rate.

**Fig. 4** is a circuit diagram of an operational amplifier embodying said second alternative technique for improving the slew-rate.

**Fig. 5** is the circuit diagram of the improved operational amplifier object of the present invention.

*DESCRIPTION OF THE BEST EMBODIMENT*

The operational amplifier of the invetion depicted in Fig. 5 retains generally common features of the prior art amplifier shown in Fig. 4 and a rehiterated description of these common features is deemed unnecessary for the comprehension of the instant invention. The distinguishing features of the amplifier of the invention are evidenced by means of a thicker line for ease of comparison.

With reference to Fig. 5, the input differential pair of transistors $Q_1$ and $Q_2$ have a collector divided in two portions so that a first portion of the collector conducts 3/4 of the emitter injected current, while the other portion conducts the remaining 1/4 of the current. $Q_9$, $Q_{10}$ and $Q_{11}$, $Q_{12}$ constitute two complementary current mirrors. The area (emitter area) of $Q_{12}$ is twice as large as the area of $Q_{11}$ and the area of $Q_{10}$ is twice as large as the area of $Q_9$.

Under steady state conditions, the current $I_{x1}$ flowing through the input transistor $Q_1$ and the current $I_{x2}$ flowing through the input transistor $Q_2$ are equal and given by:

$$I_{x1} = I_{x2} = Ib\ \frac{R_1}{R_2} = I_x$$

moreover:

$$IQ_7 = IQ_8 = \tfrac{3}{4} I_x$$
$$IQ_9 = 2 \times \tfrac{1}{4} I_x = \tfrac{1}{2} I_x$$
$$IQ_{12} = 2IQ_{11} = 2IQ_{10} = 4IQ_9 = 2I_x$$

3

Therefore the operating point current of the Darlington pair of transistors: $Q_x$, $Q_y$, constituting the intermediate gain stage of the operational amplifier, will be equal to: $2I_x$.

Under slew-rate transient conditions, it may occur that: $I_{x1}$ will tend to zero while $I_{x2}$ will tend to a maximum value ($I_{max}$) (the contrary will lead to the same conclusions).

In this condition, the following relations will hold:

$$IQ_9 = \frac{I_{max}}{4}$$

$$IQ_{11} = IQ_{10} = \frac{I_{max}}{2}$$

$IQ_{12} = I_{max}$
$IQ_2 = \frac{3}{4} I_{max}$

or for a contrary condition (i.e. $I_{x1}$ tending to $I_{max}$ and $I_{x2}$ tending to zero):

$IQ_{12} = I_{max}$
$IQ_1 = IQ_7 = IQ_8 = \frac{3}{4} I_{max}$

It is immediately evident that the "current generator" $Q_{12}$ is rendered always capable of following the current variations imposed by the input differential stage.

In other words, the slew-rate remains completely governed by the voltage across the input terminals of the amplifier and at the same time the slew-rate results perfectly symmetric for variations of the output voltage toward a positive voltage level and viceversa toward a negative voltage level.

This permits to maintain the bias currents of the entire operational amplifier relatively low without impairing the slew-rate in order to limit power dissipation.

It should be noted that the transconductance of the input differential stage is given by: $gm \approx 1/R_2$, in a first approximation, i.e. it is independent of the biasing current level.

The moderate increase of circuit complexity of the operational amplifier of the invention is apparently justified by the advantages offered and moreover the whole circuit may be easily manufactured in a monolithically integrated form.

**Claims**

1. In an operational amplifier comprising a differential input stage, an intermediate gain stage and an output buffer stage operatively connected in cascade, said differential input stage and said intermediate gain stage having respectively input and output biasing current generating means, the improvement represented by having circuit means capable of determining the generation, by said output biasing generation means of said intermediate gain stage, of a biasing current having an amplitude which is proportional to the amplitude of a differential signal fed to input terminals of said input differential stage.

2. The operational amplifier according to claim 1, wherein said circuit means for determining the generation, by said output biasing generating means of said intermediate gain stage, of a biasing current having an amplitude proportional to the amplitude of the signal fed to the input terminals of said input differential stage, comprises

   split collector means of each one of an input pair of transistors of said differential input stage;

   fractional portions of said split collector means being capable of collecting a portion of the currents flowing through the respective input transistors of said differential input stage in function of the potential

4

difference across the input terminals thereof;

two complementary current mirrors having a combined current mirroring ratio sufficient to reproduce, in an output branch of the second of said current mirrors, a current of an amplitude equal to the sum of the currents flowing through said input pair of transistors of the differential input stage;

said current reproduced by said pair of complementary current mirrors providing an output biasing current to said intermediate gain stage proportional to the potential difference across the input terminals of said differential input stage for enhancing the slew-rate of the amplifier and reducing power dissipation.

FIG.1
PRIOR ART

FIG.2
PRIOR ART

FIG.3
PRIOR ART

6

FIG.4
PRIOR ART

FIG.5

7

European
Patent Office

EUROPEAN SEARCH
REPORT

Application Number

EP 90 83 0247

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y,A | IEEE INTERNATIONAL SOLID STATE CIRCUITS CONFERENCE. vol. 25, 10 February 1982, NEW YORK US M. Gerstenhaber et al: "A Monolithic Balanced Modulator-Demodulator for instrumentation "_____pages 44,45,288,289." <br> * page 44; figures 4, 5 * | 1,2 | H 03 F 1/02 <br> H 03 F 3/45 <br> H 03 F 1/32 |
| Y | IEEE JOURNAL OF SOLID-STATE CIRCUITS. vol. sc-13, no. 6, December 1978, NEW YORK US pages 873 - 881; D.M. Monticelli: "A Versatile Monolithic IC Building-Block for Light-Sensing Applications" <br> * page 879, right-hand column, line 11 - page 880, right-hand column, line 10; figure 6 * | 1 | |
| A | IEEE JOURNAL OF SOLID-STATE CIRCUITS. vol. 24, no. 3, June 1989, NEW YORK US pages 744 - 746; R Klinke et al: "A Very-High-Slew-Rate CMOS Operational Amplifier" <br> * page 744; figure 2 * | 1 | |
| A | US-A-4 739 281 (J.G. DOYLE) <br> * column 5, lines 1 - 42; figure 3 * | 1,2 | TECHNICAL FIELDS SEARCHED (Int. Cl.5) |
| A | IEEE JOURNAL OF SOLID-STATE CIRCUITS. vol. sc-9, no. 6, December 1974, NEW YORK US pages 314 - 332; J.E. Solomon: "The Monolithic Op Amp: A Tutorial Study" <br> * page 329, right-hand column, line 9 - page 331, right-hand column, line 7; figures 27-28 * | 1,2 | H 03 F |
| E | US-A-4 935 703 (V. POLETTO) <br> * the whole document * | 1,2 | |

The present search report has been drawn up for all claims

| Place of search | Date of completion of search | Examiner |
|---|---|---|
| The Hague | 28 January 91 | TYBERGHIEN G.M.P. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document